# FASCICULE DE BREVET EUROPEEN

(11) **EP 3 896 695 B1**
(45) Date de publication et mention de la délivrance du brevet: **13.03.2024**
(21) Numéro de dépôt: 21167345.4
(22) Date de dépôt: 08.04.2021
(51) Int. Cl.: G11C 16/04, G11C 16/16, G11C 16/34, G11C 16/10, G11C 16/30

(54) **PROCÉDÉ D'ÉCRITURE DANS UNE MÉMOIRE NON-VOLATILE SUIVANT LE VIEILLISSEMENT DES CELLULES MÉMOIRES ET CIRCUIT INTÉGRÉ CORRESPONDANT**
VERFAHREN ZUM SCHREIBEN IN EINEN NICHTFLÜCHTIGEN SPEICHER IN ABHÄNGIGKEIT VON DER ALTERUNG DER SPEICHERZELLEN UND ENTSPRECHENDER INTEGRIERTER SCHALTKREIS
METHOD FOR WRITING IN A NON-VOLATILE MEMORY ACCORDING TO THE AGEING OF THE MEMORY CELLS AND CORRESPONDING INTEGRATED CIRCUIT

(30) Priorité: 14.04.2020 FR 2003730
(43) Date de publication de la demande: 20.10.2021
(73) Titulaire: STMicroelectronics (Rousset) SAS, 13790 Rousset (FR); STMicroelectronics S.r.l., Agrate Brianza (IT)
(72) Inventeur: LA ROSA, Francesco, 13790 Rousset (FR); CASTALDO, Enrico, 95128 Catania (IT); GRANDE, Francesca, 96100 Siracusa (IT); PAGANO, Santi Nunzio Antonino, 95124 Catania (IT); NASTASI, Giuseppe, 98044 San Filippo Del Mela (IT); ITALIANO, Franco, 98044 San Filippo Del Mela (IT)
(74) Mandataire: Casalonga

(56) Documents cités:
- EP-A1- 1 486 987
- US-A1- 2014 097 481
- US-A1- 2019 371 410

## Description

Des modes de réalisation et de mise en oeuvre concernent les circuits intégrés, en particulier les mémoires non-volatiles et l'écriture dans les mémoires non-volatiles.

L'écriture dans les mémoires non-volatiles, par exemple du type électriquement effaçables et programmables, « EEPROM » (pour « Electrically Erasable Programmable Read Only Memory » en anglais) comprend typiquement un cycle d'effacement suivi d'un cycle de programmation. Par exemple, le cycle d'effacement est collectif dans des cellules mémoires dites sélectionnées appartenant à une page complète (ou ligne) dite sélectionnée, tandis que la programmation est sélective selon les données à écrire (« 0 » ou « 1 ») dans les différentes cellules mémoires du mémoire sélectionné.

Lors des cycles d'effacement et de programmation, des transistors à grille flottante appartenant à chaque cellule mémoire sont polarisés à des tensions d'écriture suffisamment hautes pour engendrer une injection de charges (positives ou négatives selon la convention prise pour l'effacement et la programmation) par effet Fowler-Nordheim, ou par effet d'injection de porteurs chauds, dans la grille flottante du transistor.

Ainsi la valeur seuil (c'est-à-dire la valeur de la tension de seuil) du transistor à grille flottante à l'état effacé est différente de la valeur seuil du transistor à grille flottante à l'état programmé et cela permet de lire la donnée stockée.

Les tensions d'écritures sont de l'ordre de 10 à 15 volts en valeur absolue et sont appliquées, par exemple en effacement, entre la grille de commande et le corps du transistor à grille flottante (c'est-à-dire le substrat ou caisson logeant le transistor), ou, par exemple en programmation, entre la grille de commande et une borne de conduction du transistor à grille flottante.

Les techniques de tension partagée (« split voltage » selon le vocable anglais usuel), prévoient, pour générer les hautes tensions d'écriture, d'appliquer d'une part une tension positive d'amplitude modérée et d'autre part une tension négative d'amplitude modérée.

Cela permet notamment de réduire la taille des transistors de la mémoire, notamment les transistors acheminant les tensions d'écriture, étant donné que les contraintes en tension dans ces transistors sont modérées par les techniques de tension partagée.

Après de nombreux cycles d'effacement et de programmation, les injections de charges ont tendance à dégrader notamment les couches diélectriques traversées par les charges injectées par effet tunnel.

Cette dégradation se traduit par une dérive de la valeur seuil du transistor à l'état effacé et à l'état programmé.

Cette dérive est particulièrement plus importante dans les effacements comprenant des injections de charges entre le corps semiconducteur et la grille flottante. Par exemple, après quelques centaines de milliers de cycles d'écriture, par exemple 500000 cycles, la valeur seuil à l'état effacé peut être de l'ordre de 2 à 4 volts supérieure à la valeur seuil à l'état effacé qui résulte des premiers cycles d'effacement.

Ainsi, la distinction d'un état effacé et d'un état programmé peut devenir incertaine après un grand nombre de cycles d'écriture.

Ce phénomène de vieillissement se traduit par une limitation de l'endurance de la mémoire. L'endurance de la mémoire est une caractéristique définissant le nombre de cycles d'écriture dans lesquels un fonctionnement normal de la mémoire est garanti, autrement dit la « durée de vie » de la mémoire. L'endurance est une caractéristique importante sur le plan commercial.

Ce phénomène de vieillissement est encore plus prononcé avec la réduction de la taille des transistors de la mémoire.

Le document EP 1 486 987 A1 divulgue un procédé de contrôle et de rafraîchissement d'un transistor à grille flottante dans l'état effacé, comprenant les étapes consistant à appliquer une tension d'effacement positive sur une grille de contrôle du transistor à grille flottante, et appliquer sélectivement une tension d'effacement positive au drain du transistor à grille flottante, par exemple au moyen d'un verrou de programmation, et à porter le caisson du transistor à grille flottante à la masse ou à une tension sensiblement négative, par exemple -1,2 V.

Par ailleurs, des techniques prévoyant d'augmenter la durée des cycles d'effacement pour limiter la dérive des valeurs seuils à l'état effacé présentent l'inconvénient immédiat de ralentir les opérations d'écriture. La vitesse d'un cycle d'écriture est une caractéristique qui est elle-aussi importante sur le plan commercial.

Aussi, les techniques classiques prévoyant d'augmenter la tension d'effacement pour limiter la dérive des valeurs seuils sont typiquement limitées par les niveaux de claquages des jonctions des transistors acheminant les tensions de grille de commande.

Ainsi il existe un besoin de proposer des mémoires non-volatiles compactes présentant une endurance plus importante, sans pour autant limiter d'autres caractéristiques de la mémoire.

Selon un aspect il est proposé un procédé d'écriture dans une mémoire non-volatile comportant des cellules mémoires logées dans un caisson semiconducteur comportant chacune un transistor d'état ayant une grille flottante et une grille de commande. Le procédé comprend un cycle d'effacement comprenant une polarisation du caisson semiconducteur à une première tension d'effacement, par exemple positive, et, en réponse à une augmentation d'une valeur d'usure des cellules mémoires supérieure à une valeur seuil d'usure, une augmentation du niveau de la première tension d'effacement, en valeur absolue, à un niveau supérieur à un niveau de claquage de jonctions bipolaires d'un circuit commutateur de grille de commande de la mémoire.

Dans le procédé selon cet aspect, le cycle d'effacement peut comprendre une polarisation des grilles de commande des cellules mémoires sélectionnées à une deuxième tension d'effacement, par exemple négative, par l'intermédiaire du circuit commutateur de grille de commande.

Bien entendu, la valeur d'usure des cellules mémoire est une valeur représentative du vieillissement des cellules mémoires, déterminée à un instant donné par des circuits prévus à cet effet.

La valeur seuil d'usure peut être la valeur représentative du vieillissement des cellules mémoires à partir duquel le niveau maximal de tension dans le circuit commutateur de grilles de commande (c'est-à-dire le niveau de claquage de jonctions bipolaires) n'est plus suffisant pour empêcher une dérive de la valeur seuil des transistors d'état à l'état effacé (par exemple une dérive de l'ordre de 2 volts). Un tel vieillissement des cellules mémoires, correspondant à la valeur seuil d'usure, peut par exemple s'illustrer par 500000 cycles d'écriture mis en oeuvre dans la mémoire.

La première tension d'effacement et la deuxième tension d'effacement sont mutuellement configurées pour effacer les cellules mémoires sélectionnées, par exemple par injection de charge dans la grille flottante des transistors d'état des cellules mémoires sélectionnées, typiquement par effet Fowler-Nordheim.

En d'autres termes, le procédé selon cet aspect propose, dans une technique de tension partagée, d'augmenter l'amplitude de la tension d'effacement en augmentant en valeur absolue la composante de la tension d'effacement appliquée dans le caisson des cellules mémoires, c'est-à-dire la première tension d'effacement.

Or, la première tension d'effacement ne transite pas par le circuit commutateur de grille de commande.

Ainsi, le niveau de la première tension d'effacement n'est pas limité par le niveau de claquage des jonctions bipolaires du circuit commutateur de grille de commande.

Cela permet donc de limiter la dérive des valeurs seuils, en intensifiant les effacements dans les cellules mémoires vieillies au-delà de la limite imposée par le claquage des jonctions bipolaires du circuit commutateur de grille de commande, et donc d'augmenter l'endurance globale de la mémoire.

La mémoire peut comporter un circuit périphérique, des transistors tampons logés dans un caisson semiconducteur tampon, les cellules mémoires étant couplées au circuit périphérique par l'intermédiaire de bornes de conduction des transistors tampons, et, selon un mode de mise en oeuvre, le caisson semiconducteur tampon et les grilles des transistors tampons sont polarisés à une tension d'isolation tampon adaptée pour isoler le circuit périphérique de la première tension d'effacement.

Par exemple, des lignes de bits sont couplées à des bornes de conduction des transistors d'état des cellules mémoires, et les lignes de bits sont couplées au circuit périphérique par l'intermédiaire des bornes de conduction des transistors tampons.

Cela permet, lorsque le niveau de la première tension d'effacement est supérieur au niveau de claquage du circuit commutateur de grille de commande, de ne pas transmettre la première tension d'effacement dans le circuit périphérique, des tensions supérieures au niveau de claquage du circuit commutateur de grille de commande étant typiquement destructrices pour le circuit périphérique.

En effet, les lignes de bits, n'étant pas utilisées lors du cycle d'effacement, sont à un potentiel flottant. Ainsi, le potentiel des lignes de bits peut monter au niveau de la première tension d'effacement, éventuellement à un niveau de tension pouvant dégrader le circuit périphérique.

Or, étant donné que les grilles des transistors tampons sont polarisées à la tension d'isolation tampon, le circuit périphérique est protégé de la première tension d'effacement présente sur les lignes de bits lors de l'écriture. En outre, étant donné que le caisson semiconducteur tampon est aussi polarisé à la tension d'isolation tampon, les transistors tampons ne seront pas endommagés par la première tension d'effacement des lignes de bits.

A cet égard, lorsque la valeur d'usure est supérieure à la valeur seuil d'usure, la tension d'isolation tampon peut être au moins égale à la différence entre le niveau de la première tension d'effacement et le niveau de claquage des jonctions bipolaires du circuit commutateur de grille de commande.

Selon un mode de mise en oeuvre, une région semiconductrice d'isolation est polarisée à la première tension d'effacement, la région conductrice d'isolation enveloppant le caisson semiconducteur logeant les cellules mémoires et le caisson semiconducteur tampon, dans des structures du type triple caisson.

D'une part, cela permet d'isoler électriquement les régions semiconductrices de la mémoire vis-à-vis de la première tension d'effacement. En effet, les jonctions bipolaires entre le substrat et la région semiconductrice d'isolation sont typiquement capables de supporter des tensions supérieures à ladite tension de claquage du circuit commutateur de grille de commande.

D'autre part, la région semiconductrice d'isolation mutualisée aux structures du type triple caisson à la fois pour le caisson logeant les cellules mémoires et pour le caisson tampon, est avantageusement compacte. Cette mutualisation est notamment permise par la tension d'isolation tampon, empêchant un claquage de la jonction bipolaire entre le caisson semiconducteur tampon et la région semiconductrice d'isolation polarisée à la première tension d'effacement.

Selon un mode de mise en oeuvre, le cycle d'effacement comprend en outre, par l'intermédiaire du circuit commutateur de grille de commande, une polarisation des grilles de commande des cellules mémoires non-sélectionnées à une tension de neutralisation.

La tension de neutralisation est configurée vis-à-vis de la première tension d'effacement, appliquée dans le caisson logeant aussi les cellules mémoires non-sélectionnées, pour neutraliser des phénomènes d'effacement parasite des cellules mémoires non-sélectionnées. Cela est avantageux en matière de rétention des données.

Par exemple, la tension de neutralisation est choisie égale à la première tension d'effacement. La tension de neutralisation est néanmoins limitée par le niveau de claquage des jonctions bipolaires du circuit commutateur de grille de commande.

Selon un mode de mise en oeuvre, lorsque la valeur d'usure est inférieure à la valeur seuil d'usure, le procédé comprend une augmentation du niveau de la tension de neutralisation, en valeur absolue, de façon à maintenir un écart initial constant par rapport audit niveau de la première tension d'effacement. Dans le cas où la tension de neutralisation est choisie égale à la première tension d'effacement, l'écart initial maintenu constant est un écart nul.

Cela permet avantageusement de neutraliser des phénomènes d'effacement parasite des cellules mémoires non-sélectionnées, tandis que la première tension d'effacement augmente suivant le vieillissement des cellules mémoires.

Selon un mode de mise en oeuvre, lorsque la valeur d'usure est supérieure à la valeur seuil d'usure, le procédé comprend un décalage du niveau de la tension de neutralisation à un niveau de tension de neutralisation décalé, et une augmentation du niveau de la tension de neutralisation décalé, en valeur absolue, de façon à maintenir le décalage constant par rapport audit niveau de la première tension d'effacement.

Et, avantageusement, lorsque la valeur d'usure est supérieure à la valeur seuil d'usure, le niveau de la première tension d'effacement reste inchangé, lorsque le niveau de la tension de neutralisation atteint ledit niveau de claquage des jonctions bipolaires du circuit commutateur de grille de commande.

En d'autres termes, lorsque la première tension d'effacement dépasse la tension de claquage du circuit commutateur de grille de commande, on décale le niveau de la tension de neutralisation de façon à ce qu'il ne dépasse pas le niveau de la tension de claquage. Ensuite, la tension de neutralisation suit l'évolution de la première tension d'effacement sans dépasser la tension de claquage, du fait du décalage. Lorsque la tension de neutralisation atteint, à une marge de prudence près, le niveau de la tension de claquage des jonctions bipolaires du circuit commutateur de grille de commande, on arrête d'augmenter la première tension d'effacement.

Maintenir un décalage constant au cours de l'augmentation de la première tension d'effacement, au-delà de la valeur seuil d'usure, est avantageux en matière de régulation des tensions générées, et permet de bien maîtriser les phénomènes d'effacement parasite issus de cette différence constante. A cet égard, le procédé peut prévoir une compensation des effacements parasites par des mécanismes classiques, par exemple des algorithmes dits « de rafraîchissement ».

Selon un autre mode de mise en oeuvre, lorsque la valeur d'usure est supérieure à la valeur seuil d'usure, le niveau de la première tension d'effacement reste inchangé, à un niveau égal à une marge de tolérance prise sur ledit niveau de claquage des jonctions bipolaires du circuit commutateur de grille de commande.

Dans cet autre mode de mise en oeuvre, le niveau de la tension de neutralisation n'est pas décalé et reste constant au-delà de la valeur seuil d'usure. Ainsi, l'écart entre le niveau de la première tension d'effacement et le niveau de la tension de neutralisation augmente suivant l'évolution du niveau de la première tension d'effacement. En conséquence, les phénomènes d'effacement parasites dans les cellules mémoires non-sélectionnées sont éventuellement moins bien maîtrisés mais sont plus faibles au début qu'à la fin de la période commençant au-delà de la valeur seuil d'usure.

Selon un autre aspect, il est proposé un circuit intégré de mémoire non-volatile comprenant :
- des cellules mémoires logées dans un caisson semiconducteur et comportant chacune un transistor d'état ayant une grille flottante et une grille de commande,
- des moyens d'effacement configurés, lors d'un cycle d'effacement, pour polariser le caisson semiconducteur à une première tension d'effacement, par exemple positive, les moyens d'effacement étant configurés, en réponse à une augmentation d'une valeur d'usure des cellules mémoires supérieure à une valeur seuil d'usure, pour augmenter le niveau de la première tension d'effacement, en valeur absolue, à un niveau supérieur à un niveau de claquage des jonctions bipolaires d'un circuit commutateur de grille de commande.

Selon un mode de réalisation, les moyens d'effacement sont configurés, lors du cycle d'effacement, pour polariser les grilles de commande des cellules mémoires sélectionnées à une deuxième tension d'effacement, par exemple négative, par l'intermédiaire du circuit commutateur de grille de commande.

Selon mode de réalisation, le circuit intégré comporte en outre un circuit périphérique, des transistors tampons logés dans un caisson semiconducteur tampon, et les cellules mémoires sont couplées au circuit périphérique par l'intermédiaire de bornes de conduction des transistors tampons, le caisson semiconducteur tampon et les grilles des transistors tampons étant destinés à être polarisés à une tension d'isolation tampon adaptée pour isoler le circuit périphérique de la première tension d'effacement.

Selon un mode de réalisation, lorsque la valeur d'usure est supérieure à la valeur seuil d'usure, un circuit de distribution est configuré pour générer la tension d'isolation tampon au moins égale à la différence entre le niveau de la première tension d'effacement et le niveau de claquage des jonctions bipolaires du circuit commutateur de grille de commande.

Selon un mode de réalisation, le caisson semiconducteur logeant les cellules mémoires est enveloppé par une région semiconductrice d'isolation dans une structure du type triple caisson, et le caisson semiconducteur tampon est également enveloppé par la même région semiconductrice d'isolation, dans une structure du type triple caisson, la région semiconductrice d'isolation étant destinée à être polarisée à la première tension d'effacement.

Selon un mode de réalisation, les moyens d'effacement sont en outre configurés, lors d'un cycle d'effacement, pour polariser les grilles de commande des cellules mémoires non-sélectionnées à une tension de neutralisation, par l'intermédiaire du circuit commutateur de grille de commande.

Selon un mode de réalisation, lorsque la valeur d'usure est inférieure à la valeur seuil d'usure, les moyens d'effacement sont configurés pour augmenter le niveau de la tension de neutralisation, en valeur absolue, de façon à maintenir un écart initial constant par rapport audit niveau de la première tension d'effacement.

Selon un mode de réalisation, lorsque la valeur d'usure est supérieure à la valeur seuil d'usure, les moyens d'effacement sont configurés pour décaler le niveau de la tension de neutralisation à un niveau de tension de neutralisation décalé, et augmenter le niveau de la tension de neutralisation décalé, en valeur absolue, de façon à maintenir le décalage constant par rapport audit niveau de la première tension d'effacement.

Selon un mode de réalisation, lorsque la valeur d'usure est supérieure à la valeur seuil d'usure, les moyens d'effacement sont configurés pour maintenir inchangé le niveau de la première tension d'effacement lorsque le niveau de la tension de neutralisation atteint ledit niveau de claquage des jonctions bipolaires du circuit commutateur de grille de commande.

Selon un mode de réalisation, lorsque la valeur d'usure est supérieure à la valeur seuil d'usure, les moyens d'effacement sont configurés pour maintenir inchangé le niveau de la première tension d'effacement, lorsque le niveau de la première tension d'effacement est égal à une marge de tolérance prise sur ledit niveau de claquage des jonctions bipolaires du circuit commutateur de grille de commande.

D'autres avantages et caractéristiques de l'invention apparaîtront à l'examen de la description détaillée de modes de réalisation et de de mise en oeuvre, nullement limitatifs, et des dessins annexés, sur lesquels :
[Fig 1]
[Fig 2]
[Fig 3]
[Fig 4]
[Fig 5]

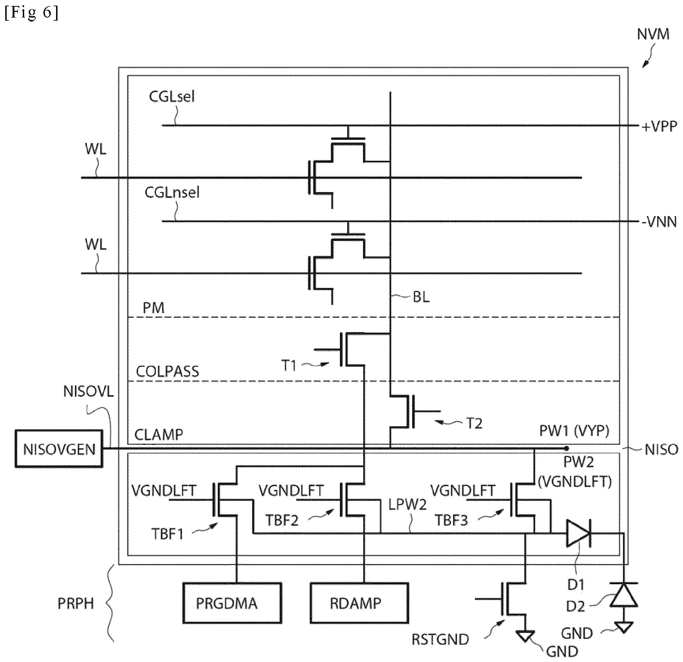

[Fig 6] illustrent des modes de réalisation et de mise en oeuvre de l'invention.

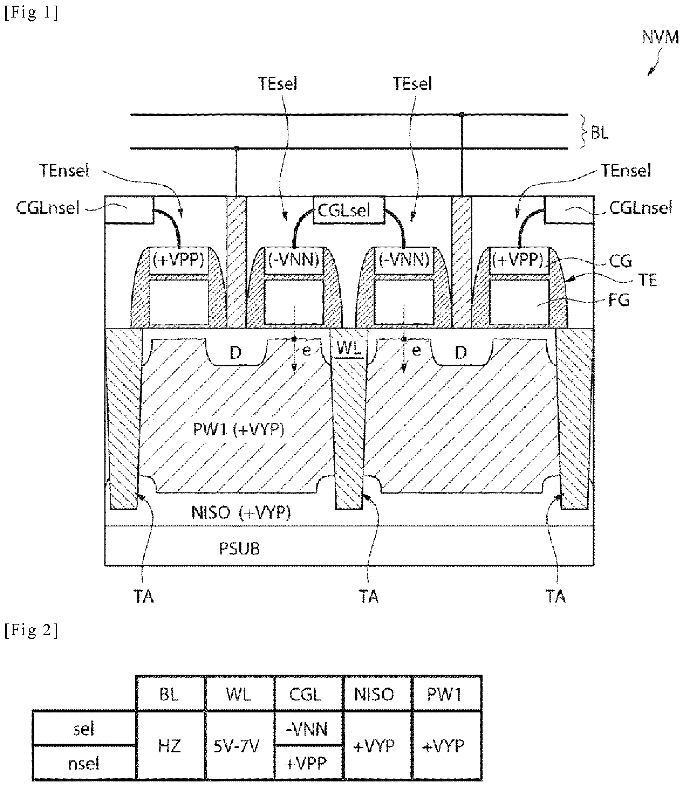

La figure 1 illustre une vue en coupe d'un exemple de cellules mémoires d'un circuit intégré de mémoire non-volatile NVM.

Une cellule mémoire comporte un transistor d'état TE (soit TEsel, soit TEnsel, selon que le transistor d'état TE est sélectionné ou, respectivement, non-sélectionné) et un transistor d'accès TA couplés en série.

Les cellules mémoires sont logées dans et sur un caisson semiconducteur PW1, typiquement dopé de type P.

Le caisson PW1 loge les cellules mémoires dans un plan mémoire PM (figure 6), typiquement arrangé en matrice de rangées et de colonnes.

Les transistors d'état TE (TEsel, TEnsel) comportent une grille flottante FG et une grille de commande CG, la grille flottante FG étant électriquement isolée du caisson PW1 par une couche diélectrique dite « tunnel », et électriquement isolée de la grille de commande CG par une couche diélectrique dite « de grille ».

Dans cet exemple, le transistor d'accès TA est un transistor enterré à grille verticale, et est partagé pour deux transistors d'état TE (TEsel, TEnsel) de part et d'autre de la grille verticale. La grille verticale remplit une tranchée gravée verticalement dans le caisson PW1, les flancs et le fond de la tranchée étant recouverts d'une couche de diélectrique de grille.

Les grilles verticales des transistors d'accès TA forment par ailleurs une ligne de mot WL s'étendant dans la direction perpendiculaire au plan de la figure 1, commune par exemple à une rangée de cellules mémoires.

Une région semiconductrice enterré NISO permet d'une part d'isoler électriquement le caisson PW1 logeant les cellules mémoires du substrat semiconducteur PSUB, et d'autre part de former la région de source des transistors d'accès TA.

Le caisson PW1 logeant les cellules mémoires est en effet isolé du substrat semiconducteur PSUB par la région semiconductrice enterré NISO et par des caissons d'isolation dopés de type N latéralement autour du caisson PW1, selon une structure de caisson isolé dite « triple caisson ». Cela permet notamment de polariser le caisson PW1 avec des potentiels positifs.

Les drains des transistors d'accès TA sont situés en surface du caisson PW1, et forment en même temps les régions de sources des transistors d'état TEsel respectifs. Les régions de drains des transistors d'état TEsel, TEnsel sont couplées via des contacts à des lignes de bits BL dans les premiers niveaux de la partie d'interconnexion du circuit intégré.

Pour enregistrer des données dans la mémoire, des moyens d'écriture sont configurés pour sélectionner logiquement les cellules mémoires à écrire, les cellules mémoires à ne pas écrire étant dites non-sélectionnées.

Des moyens d'effacement (non représentés) sont configurés pour effacer collectivement les cellules mémoires appartenant à au moins une page sélectionnée, lors d'un cycle d'effacement. Une page de la mémoire est un groupe de cellules mémoires, typiquement une rangée entière de cellules mémoires, dans l'organisation matricielle du plan mémoire.

Des moyens de programmation (non représentés) sont quant à eux configurés pour programmer sélectivement les cellules mémoires, lors d'un cycle d'effacement. Par exemple un cycle de programmation comprend une polarisation de la ligne de grille de commande CGLsel collective à une première tension de programmation, et une polarisation des lignes de bits BL, sélectivement selon la donnée à stocker, à une deuxième tension de programmation.

On se réfère à la figure 2.

La figure 2 illustre un exemple de mise en oeuvre d'un cycle d'effacement de la mémoire NVM décrite ci-dessus en relation avec la figure 1.

Lors du cycle d'effacement, les moyens d'effacement sont configurés pour polariser le caisson semiconducteur PW1 à une première tension d'effacement VYP, et pour polariser des lignes de grille de commande sélectionnées CGLsel à une deuxième tension d'effacement -VNN.

On considérera dans la suite la convention usuelle dans laquelle la première tension d'effacement VYP est de signe positif, et la deuxième tension d'effacement VNN est de signe négatif. La première tension d'effacement VYP pourra ainsi être désigné par « tension d'effacement positive », et la deuxième tension d'effacement VNN par « tension d'effacement négative ».

Cela étant, on pourra envisager d'adapter les modes de réalisation et de mise en oeuvre décrits ci-après à des tensions de signes opposés, et notamment dans un caisson logeant les cellules mémoires de conductivité opposée (de type N), en considérant des augmentations sur les valeurs absolues des tensions de signe négatif.

La tension d'effacement positive VYP et la tension d'effacement négative -VNN sont mutuellement configurées pour produire un transfert de charge « e » de la grille flottante des transistors d'état TEsel des cellules mémoires sélectionnées vers le caisson PW1, typiquement par un effet Fowler-Nordheim à travers la couche diélectrique tunnel.

En outre, lors du cycle d'effacement, les moyens d'effacement sont configurés pour polariser les lignes de grilles de commande non-sélectionnées CGLnsel à une tension de neutralisation +VPP, de signe positif dans cet exemple.

La tension de neutralisation +VPP permet de neutraliser des phénomènes d'effacement parasite dans les transistors d'état non-sélectionnées TEnsel, potentiellement causés par la tension d'effacement positive VYP appliquée dans le caisson PW1 logeant aussi les cellules mémoires non-sélectionnées. Par exemple, la tension de neutralisation +VPP est initialement choisie égale à la tension d'effacement positive VYP.

Par ailleurs, les lignes de bits BL sont laissées à un potentiel flottant HZ ; les transistors d'accès TA sont polarisés à sensiblement 5V ou 7V (volts) sur leurs grilles verticales pour limiter le stress provoqué sur leur oxide de grille par la tension d'effacement positive VYP dans le caisson PW1 ; et la région semiconductrice enterrée d'isolation NISO est polarisée à la tension d'effacement positive VYP.

Ainsi, le cycle d'effacement comprend notamment une polarisation de la ligne de grille de commande sélectionnée CGLsel à une tension d'effacement négative -VNN, et une polarisation des lignes de grilles de commande non-sélectionnées CGLnsel à une tension de neutralisation positive +VPP.

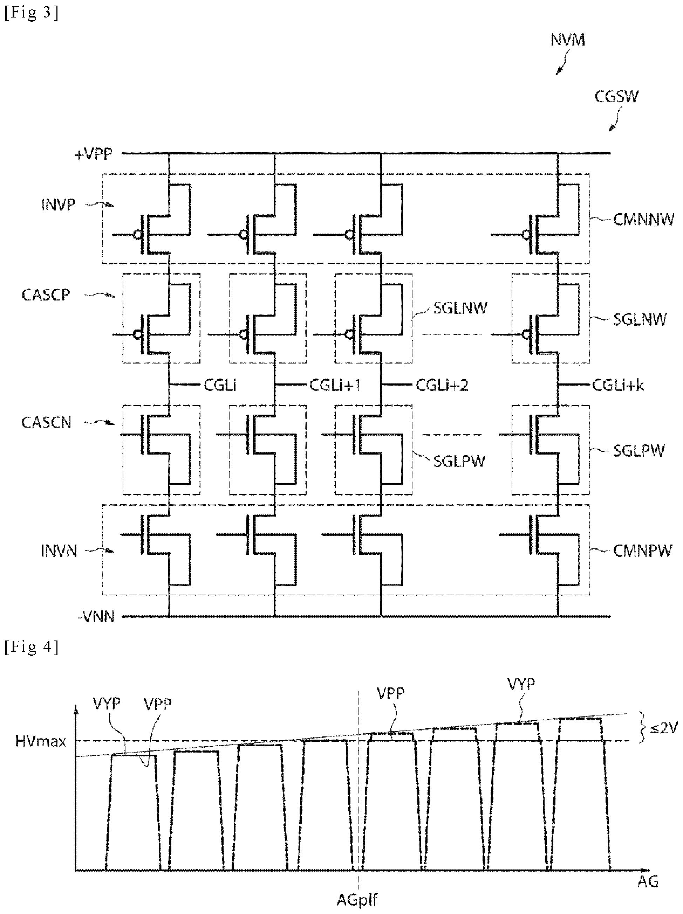

On se réfère à la figure 3.

La figure 3 représente un exemple de circuit commutateur de grille de commande GCSW utilisé pour transmettre la tension d'effacement négative -VNN ou la tension de neutralisation positive +VPP dans les lignes de grilles de commande CGLi, CGLi+1, CGLi+2, ..., CLGi+k des cellules mémoires.

Le commutateur de grille de commande CGSW transmet sélectivement la tension d'effacement négative -VNN ou la tension de neutralisation positive +VPP selon que les cellules mémoires d'une page sont sélectionnées ou non-sélectionnées pour l'effacement. Le commutateur de grille de commande CGSW décode à cet égard un signal de commande de sélection au moyen de circuits du type inverseurs, en technologie complémentaire haute tension HVMOS (pour « High Voltage Métal Oxide Semiconductor » en anglais, technologie bien connue de l'homme de l'art).

Ainsi, des transistors PMOS des inverseurs INVP sont formés dans un caisson semiconducteur de type N commun CMNPW, et des transistors NMOS des inverseurs INVN sont formés dans un caisson semiconducteur de type P commun CMNPW. Par ailleurs, des transistors PMOS et NMOS du type cascode CASP, CASCN peuvent être prévus sur les sorties CGLi - CGLi+k des inverseurs, et sont formés dans des caissons isolés SGLNW, SGLPW.

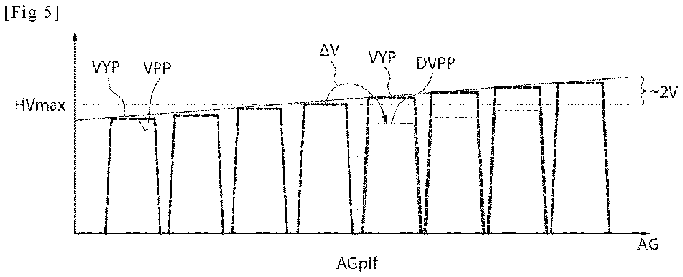

Ainsi, dans le circuit commutateur de grille de commande CGSW, le maximum de la différence de potentiel (HVmax, figures 4 et 5) entre la tension de neutralisation positive +VPP et la tension d'effacement négative -VNN est limité par les caractéristiques des transistors HVMOS (INVP, INVN, CASCP, CASCN). En particulier, les jonctions bipolaires entre les régions de conduction (notamment les régions de drain, étant donné que les caissons sont typiquement polarisés par les potentiels des régions de source) des transistors HVMOS et les caissons respectifs sont typiquement limitées par leur niveau de claquage (HVmax), par exemple à sensiblement 11V.

Par conséquent, pour intensifier les stimuli d'effacement, c'est-à-dire les conditions en tension des cycles d'effacement, il n'est pas envisageable d'augmenter, en valeur absolue, le niveau des tensions VPP, VNN passant par l'intermédiaire du circuit commutateur de grille de commande CGSW.

Or, lorsque les cellules mémoires vieillissent, les cycles d'effacement sont moins efficaces pour les mêmes tensions d'effacement qu'en début de vie de la mémoire NVM.

Ce phénomène de vieillissement est typiquement causé par une dégradation de l'oxide de grille flottante ayant subi un grand nombre de cycles d'effacement, par exemple de l'ordre de 500000 cycles.

A cet égard, les moyens d'effacement sont configurés pour augmenter le niveau de la tension d'effacement positive VYP suivant le vieillissement des cellules mémoires.

Par exemple, les moyens d'écriture ou les moyens d'effacement (non-représentés) sont configurés pour évaluer la valeur d'usure (AG) représentative du vieillissement des cellules mémoires en faisant une lecture « en mode marge » (« margin mode » en anglais) dans les cellules mémoires après chaque application de stimuli d'effacement. La lecture en mode marge est une lecture qui mesure de façon quantifiée la valeur seuil des transistors à grille flottantes TEsel. Les moyens d'écriture peuvent dans ce cas être configuré pour mettre en oeuvre une répétition de cycles d'effacements itérative en boucle fermée, jusqu'à obtenir un état correctement effacé.

En alternative, les moyens d'écriture ou d'effacement peuvent évaluer la valeur d'usure représentative du vieillissement des cellules mémoires (AG, figures 4 et 5) à partir d'un enregistrement de la dernière valeur des tensions d'effacement VYP, VNN. En effet, les moyens d'écriture ou d'effacement peuvent être automatisés pour mesurer régulièrement les états effacés « en mode marge », et augmenter si besoin les valeurs des tensions d'effacement VYP, VNN. Les nouvelles valeurs des tensions d'effacement VYP, VNN sont enregistrées et serviront de référence pour évaluer la valeur d'usure AG lors d'un prochain cycle effacement.

Le niveau de la tension d'effacement positive VYP peut ainsi être augmenté suivant l'évolution de la valeur d'usure (AG).

Comme la tension d'effacement positive VYP polarise le caisson PW1 et ne transite pas par les circuits commutateur de grille de commande CGSW, cette tension d'effacement positive n'est pas directement limitée par le niveau de claquage (HVmax) des jonctions bipolaires desdits circuits CGSW.

Ainsi, le niveau de la tension d'effacement positive VYP peut être supérieur à un niveau de claquage (HVmax) du commutateur de grille de commande CGSW. Cela permet d'intensifier les conditions en tension des cycles d'écritures, lorsque le vieillissement des cellules mémoires est tel que les niveaux maximaux de tensions positive (VPP) et négative (VNN) du circuit commutateur de grille de commande CGSW sont atteint et ne sont plus suffisant pour engendrer des états effacés rigoureusement discriminables vis-à-vis des états programmés.

On se réfère à cet égard aux figures 4 et 5.

Les figures 4 et 5 représentent deux exemples de mises en oeuvre du procédé d'écriture dans la mémoire NVM décrite précédemment en relation avec les figures 1 à 3.

Les figures 4 et 5 illustrent l'évolution des niveaux des tensions positives en jeu lors des cycles d'effacement, c'est-à-dire la tension d'effacement positive VYP appliquée dans le caisson PW1 et la tension de neutralisation VPP appliquée dans les grilles de commandes CG des transistors d'état non-sélectionnés TEnsel.

Dans les deux exemples, le procédé comprend une augmentation du niveau de la tension d'effacement positive VYP résultant de l'augmentation de la valeur d'usure AG représentative du vieillissement des cellules mémoires. En conséquence, l'amplitude des stimuli d'effacement est augmentée afin de limiter la dérive des valeurs seuils des cellules mémoires vieillies, permettant donc d'augmenter l'endurance globale de la mémoire.

Par exemple, l'augmentation du niveau de la tension d'effacement positive VYP résulte de l'augmentation de la valeur d'usure AG en ce qu'elles sont proportionnelles. L'augmentation du niveau de la tension d'effacement positive VYP peut aussi être segmentée par paliers, dont les niveaux augmentent proportionnellement avec l'augmentation de la valeur d'usure AG.

On rappelle que la valeur d'usure AG peut être obtenue directement ou dérivée d'une lecture en mode marge de cellules mémoires effacées.

La tension de neutralisation VPP est configurée vis-à-vis de la tension d'effacement positive VYP pour neutraliser des phénomènes d'effacement parasite des cellules mémoires non-sélectionnées TEnsel.

La tension de neutralisation peut être choisie égale à, ou proche de, la tension d'effacement positive VYP.

Le procédé comprend ainsi une augmentation du niveau de la tension de neutralisation VPP résultant de l'augmentation du niveau de la tension d'effacement positive VYP.

Si la tension de neutralisation VPP et la tension d'effacement positive VYP sont initialement différentes, l'augmentation de la tension de neutralisation VPP est mise en oeuvre de façon à maintenir la différence initiale constante.

La tension de neutralisation VPP est limitée par le niveau de claquage du commutateur de grille de commande CGSW, étant donné qu'elle est transmise sur les lignes de grilles de commandes des cellules mémoires non-sélectionnées TEnsel.

Ainsi, dans l'exemple de la figure 4, lorsque la tension de neutralisation VPP a augmenté jusqu'à atteindre le niveau maximal HVmax du circuit commutateur de grille de commande CGSW, la tension de neutralisation VPP est fixée à ce niveau maximal HVmax et n'augmente plus suivant la valeur d'usure AG des cellules mémoires.

Bien entendu, par niveau maximal, on entend une marge de prudence prise sur le niveau de claquage de jonctions bipolaires du circuit commutateur de grille de commande CGSW.

On définit une valeur seuil AGplf de la valeur d'usure AG (qui sera désignée ci-après « valeur seuil d'usure AGplf ») comme la valeur d'usure à laquelle la tension d'effacement positive VYP et la tension de neutralisation VPP atteignent le niveau maximal HVmax.

Au-delà de la valeur seuil d'usure AGplf, on arrête d'augmenter le niveau de la tension de neutralisation VPP, mais on continue d'augmenter le niveau de la tension d'effacement positive VYP à des niveaux supérieurs au niveau maximal HVmax et à des niveaux supérieurs au niveau de claquage des jonctions bipolaires du circuit commutateur de grille de commande CGSW.

L'augmentation de la tension d'effacement positive VYP résulte encore de l'augmentation de la valeur d'usure AG, de la même façon qu'en deçà de la valeur seuil d'usure AGplf, c'est-à-dire proportionnellement à l'augmentation de la valeur d'usure AG, éventuellement par paliers.

Ainsi, au-delà de la valeur seuil d'usure AGplf, l'écart entre la tension d'effacement positive VYP et la tension de neutralisation VPP augmente en suivant l'augmentation de l'usure AG des cellules mémoires. Cela introduits des phénomènes d'effacement parasites augmentant progressivement à partir de la valeur seuil d'usure AGplf.

Il existe des méthodes pour compenser ce type de phénomène parasite, par exemple par des algorithmes de rafraîchissement.

On arrête d'augmenter le niveau de la tension d'effacement positive VYP lorsqu'il est supérieur d'une marge de tolérance par rapport audit niveau de claquage HVmax du commutateur de grille de commande CGSW.

Par exemple la marge de tolérance est choisie à 2V, notamment afin de limiter les phénomènes d'effacements parasites et de pouvoir aisément les compenser par des méthodes du type « rafraîchissement ».

Dans l'exemple de la figure 5, au-delà de la valeur seuil d'usure AGplf, le procédé comprend d'une part un décalage ΔD du niveau de la tension de neutralisation VPP pour obtenir une tension de neutralisation décalée DVPP, et d'autre part une augmentation du niveau de la tension de neutralisation décalée DVPP, tout en maintenant le décalage ΔD (entre le niveau de la tension de neutralisation décalée DVPP et le niveau de la tension d'effacement positive VYP) constant.

Le niveau de la tension d'effacement positive VYP continue d'augmenter en suivant l'augmentation de la valeur d'usure AG.

Ainsi, du fait du décalage ΔD, la tension de neutralisation VPP peut elle-aussi continuer de suivre l'évolution de la tension d'effacement positive VYP sans dépasser le niveau maximal HVmax.

Et, lorsque la tension de neutralisation VPP atteint, à une marge de prudence près, le niveau de la tension de claquage HVmax du commutateur de grille de commande CGSW, on arrête d'augmenter la tension d'effacement positive VYP.

Maintenir le décalage ΔD constant au cours de l'augmentation de la tension d'effacement positive VYP, permet de faciliter la régulation des tensions positives VYP, VPP générées, et permet aussi de bien maîtriser la compensation des phénomènes d'effacement parasite issus de cette différence constante.

Par exemple le décalage ΔD est fixé à sensiblement 2V, de façon à limiter les phénomènes d'effacement parasites et de pouvoir aisément les compenser par des méthodes du type « rafraîchissement ».

Par exemple, la tension d'effacement positive VYP et la tension de neutralisation positive VPP sont générée sur une même sortie d'un circuit de pompe de charge (non représenté), tant que lesdites tensions positives VYP, VPP sont égales, c'est-à-dire avant d'avoir atteint la valeur seuil d'usure AGplf. Après avoir atteint la valeur seuil d'usure AGplf, un étage supplémentaire de pompe de charge peut être parallèlement couplé pour fournir, sur une sortie distincte, la tension d'effacement positive VYP alors supérieure à la tension de neutralisation positive VPP. Maintenir constant l'écart ΔV entre la tension d'effacement positive VYP et la tension de neutralisation positive DVPP, permet avantageusement de mutualiser la régulation desdites tensions positives VYP, DVPP, au moins sur les étages de pompe de charge commun à leurs générations.

Ainsi, dans les deux exemples décrits ci-dessus en relation avec les figures 4 et 5, le procédé comprend une augmentation du niveau de la tension d'effacement positive VYP supérieur à la tension de claquage HVmax, afin de continuer à augmenter l'amplitude des stimuli d'effacement pour limiter la dérive des valeurs seuils des cellules mémoires vieillies, permettant donc d'augmenter l'endurance globale de la mémoire, bien au-delà de la valeur seuil d'usure AGplf.

La figure 6 illustre, dans une vue d'ensemble et du dessus, un exemple de réalisation avantageux de la mémoire NVM telle que décrite précédemment en relation avec les figures 1 à 5.

Le caisson PW1 loge les cellules mémoires dans un plan mémoire PM, typiquement arrangé en matrice de rangées et de colonnes. Notamment les lignes de grilles de commande CGLi-CGLi+k ainsi que les lignes de mots WL parcourent le plan mémoire dans le sens des rangées, tandis que les lignes de bits BL et des lignes de décodage de grille de commande envoyées au circuit commutateur de grille de commande CGSW parcourent le plan mémoire PM dans le sens des colonnes.

Le caisson PW1 loge en outre des transistors T1 d'un décodeur de colonnes COLPASS ainsi que des transistors T2 d'un dispositif de mise à la masse CLAMP des lignes de bits BL.

Le caisson semiconducteur PW1 logeant les cellules mémoires et est isolés du reste du circuit par une structure du type « triple caisson », dans laquelle une région semiconductrice d'isolation NISO enveloppe le caisson PW1.

La région semiconductrice d'isolation NISO a une conductivité opposée à la conductivité du caisson PW1 logeant le plan mémoire, et est polarisée à la même tension que le caisson PW1 qu'elle enveloppe.

L'isolation se fait par des jonctions bipolaires inverses l'une à l'autre entre le caisson PW1 et la région d'isolation NISO et entre la région d'isolation NISO et le substrat semiconducteur.

Une ligne de polarisation de la région d'isolation NISOVL permet de commander une polarisation dans la région d'isolation NISO et dans le caisson logeant les cellules mémoire PW1.

Un circuit de distribution NISOVGEN est configuré pour transmettre la tension de polarisation, pouvant notamment avoir le niveau de la tension d'effacement positive VYP lors des cycles d'effacement. Par exemple, le circuit de distribution NISOVGEN comporte un circuit de verrou élévateur de tension. Le circuit de verrou élévateur de tension est configuré pour faire basculer le verrou (du type deux inverseurs tête-bêche, la sortie de l'un rebouclant sur l'entrée de l'autre) de façon à fournir en sortie une tension de niveau haut ; et ensuite pour augmenter une tension de référence basse de façon à décaler positivement la sortie jusqu'au niveau de la tension d'effacement positive VYP.

En dehors des cycles d'effacement, la ligne de polarisation de la région d'isolation NISOVL est ramenée à un potentiel de référence de masse GND, notamment au moyen d'un transistor de réinitialisation RSTGND tel que décrit ci-après.

Les bornes de conduction des transistors T2 du dispositif de mise à la masse CLAMP des lignes de bits BL sont couplées d'une part aux lignes de bits BL du plan mémoire PM et d'autre part à une ligne de polarisation de la région d'isolation NISOVL. Les transistors T2 du dispositif de mise à la masse CLAMP servent à porter les lignes de bits BL non-utilisées soit au potentiel de masse GND présent sur la ligne de polarisation de la région d'isolation NISOVL, soit à haute impédance HZ, de façon à laisser les lignes de bits BL à un potentiel flottant.

Les bornes de conduction des transistors T1 du décodeur de colonnes COLPASS sont couplés d'une part aux lignes de bits BL du plan mémoire PM, et d'autre part à des dispositifs d'un circuit périphérique PRPH.

Le circuit périphérique PRPH de la mémoire NVM comporte notamment un circuit de programmation et d'accès direct en mémoire PRGDMA et un circuit de lecture RDAMP.

Le circuit de programmation et d'accès direct en mémoire PRGDMA est utilisé notamment lors des cycles de programmation pour polariser sélectivement une ligne de bit BL décodée. Le circuit de lecture RDAMP est configuré pour détecter une variation de tension ou de courant sur une ligne de BL, représentative de l'état d'une cellule mémoire, dont le transistor d'état est par ailleurs commandé à une tension de lecture. Le circuit de lecture RDAMP peut être capable d'effectuer des lectures des cellules mémoires en mode marge.

Les dispositifs du circuit périphérique PRPH ne sont typiquement pas capables de supporter des tensions supérieures au niveau maximal HVmax décrit ci-avant en relation avec notamment les figures 4 et 5.

Or, dans les lignes de bits BL, étant laissée à un potentiel flottant lors des cycles d'effacement, le potentiel peut monter au niveau de la tension d'effacement positive VYP, à une valeur seuil de jonction bipolaire près. Par conséquent, la tension présente dans les lignes de bits BL lors des cycles d'effacement peut monter à un niveau supérieur au niveau de claquage du circuit périphérique PRPH.

Ainsi, il est avantageusement prévu un caisson semiconducteur tampon PW2, du même type de conductivité que le caisson PW1 du plan mémoire PM, logeant des transistors tampons TBF1, TBF2, TBF3.

Les transistors tampons TBF1, TBF2 sont configurés pour protéger le circuit périphérique PRPH des hautes valeurs possibles du niveau de la tension d'effacement positive VYP sur les lignes de bits BL.

En effet, d'une part les lignes de bits BL sont couplées au circuit périphérique PRPH par l'intermédiaire des bornes de conductions des transistors tampons TBF1, TBF2, TBF3. En particulier, les éléments PRGDMA, RDAMP du circuit périphérique PRPH sont couplés aux sources des transistors tampons TBF1, TBF2, tandis que les lignes de bits BL sont couplées aux drains des transistors tampons TBF1, TBF2.

D'autre part, le caisson tampon PW2 et les grilles des transistors tampons TBF1-TBF3 sont polarisés à une tension d'isolation tampon VGNDLFT, par exemple générée par un circuit de commande d'isolation tampon (non représenté).

La source de l'un des transistors tampons, dit transistor tampon de commande, TBF3 est couplée à une ligne de polarisation LPW2 du caisson tampon PW2. La polarisation du caisson tampon PW2 est ainsi commandée par la tension de grille VGNFLFT du transistor tampon de commande TBF3.

Un transistor de réinitialisation RSTGND est prévu par ailleurs dans le circuit périphérique PRPH pour repolariser le caisson tampon PW2 et la ligne de polarisation de la région d'isolation NISOVL au potentiel de référence de masse GND, en dehors des cycles d'écriture. Le transistor de réinitialisation RSTGND est bloqué lors des cycles d'écriture.

La tension d'isolation tampon VGNDLFT est par exemple au moins égale à la différence entre le niveau de la tension d'effacement positive VYP et le niveau de claquage HVmax du commutateur de grille de commande CGSW.

Ainsi, étant donné que les grilles des transistors tampons TBF1-TBF3 sont polarisées à la tension d'isolation tampon VGNDLFT, le circuit périphérique PRPH est protégé de la tension d'effacement positive VYP présente sur les lignes de bits BL (à une tension de seuil de jonction bipolaire près) lors des cycles d'effacement.

En effet, étant donné que les transistors tampons TBF1, TBF2, TBF3 sont commandés avec la tension d'isolation tampon VGNDLFT sur leurs grilles, leurs sources ne pourront pas être polarisées au-dessus de cette tension d'isolation tampon VGNDLFT.

En outre, étant donné que le caisson semiconducteur tampon PW2 est aussi polarisé à la tension d'isolation tampon VGNDLFT, les transistors tampons ne seront pas endommagés par la tension d'effacement positive VYP des lignes de bits BL, du fait du choix mentionné ci-avant du niveau de la tension d'isolation tampon VGNDLFT.

Par ailleurs, la tension d'isolation tampon VGNDLFT peut avantageusement provenir du circuit de distribution NISOVGEN de la tension d'effacement positive VYP.

En effet, pour distribuer la tension d'effacement positive VYP (qui, on le rappelle, peut être supérieure à la tension de claquage de jonctions bipolaires du circuit) le circuit de distribution NISOVGEN est par exemple configuré pour faire basculer un circuit de verrou de façon à fournir en sortie une tension de niveau haut, initialement à VPP=HVmax.

Ensuite, le circuit de distribution NISOVGEN augmente une tension de référence basse GND du verrou, d'une tension VGNDLFT, afin de décaler la sortie (initialement à VPP) positivement de VGNDLFT jusqu'au niveau de la tension d'effacement positive VYP, soit VPP+VGNDLFT=VYP, sans claquer les jonctions des transistors du verrou.

En d'autres termes, selon un exemple de réalisation et de mise en oeuvre, au-delà de la valeur seuil d'usure AGplf, ladite augmentation du niveau de la tension d'effacement positive VYP peut comprendre un décalage VGNDLFT d'une tension de référence basse GND dans un verrou élévateur NISOVGEN dont la sortie a été verrouillée à une tension de référence haute VPP pour décaler le niveau de la sortie jusqu'au niveau de la tension d'effacement positive VYP, supérieur audit niveau de claquage HVmax des jonctions bipolaires du circuit commutateur de grille de commande CGSW.

Par ailleurs, le caisson semiconducteur PW1 logeant les cellules mémoires et le caisson semiconducteur tampon PW2 sont tous les deux isolés du reste du circuit par des structures du type « triple caisson », utilisant avantageusement la même région semiconductrice d'isolation NISO pour envelopper les deux caissons PW1, PW2.

L'isolation se fait par deux jonctions bipolaires inverses, représentées par les diodes D1 et D2 couplées en série dans des polarités inverses.

## Revendications

1. Procédé d'écriture dans une mémoire non-volatile (NVM) comportant des cellules mémoires logées dans un caisson semiconducteur (PW1) comportant chacune un transistor d'état ayant une grille flottante et une grille de commande, le procédé comprenant un cycle d'effacement comprenant une polarisation du caisson semiconducteur (PW1) à une première tension d'effacement (VYP), **caractérisé en ce que** le procédé comprend, en réponse à une augmentation d'une valeur d'usure des cellules mémoires (AG) supérieure à une valeur seuil d'usure (AGplf), une augmentation du niveau de la première tension d'effacement (VYP), en valeur absolue, à un niveau supérieur à un niveau de claquage (HVmax) de jonctions bipolaires d'un circuit commutateur de grille de commande (CGSW) de la mémoire (NVM).

2. Procédé selon la revendication 1, dans lequel le cycle d'effacement comprend une polarisation des grilles de commande des cellules mémoires sélectionnées à une deuxième tension d'effacement (VNN), par l'intermédiaire du circuit commutateur de grille de commande (CGSW).

3. Procédé selon l'une des revendications 1 ou 2, la mémoire comportant un circuit périphérique (PRPH), des transistors tampons (TBF1, TBF2) logés dans un caisson semiconducteur tampon (PW2), les cellules mémoires étant couplées au circuit périphérique (PRPH) par l'intermédiaire de bornes de conduction des transistors tampons (TBF1, TBF2), dans lequel caisson semiconducteur tampon (PW2) et les grilles des transistors tampons (TBF1, TBF2) sont polarisés à une tension d'isolation tampon (VGNDLFT) adaptée pour isoler le circuit périphérique de la première tension d'effacement (VYP).

4. Procédé selon la revendication 3, dans lequel, lorsque la valeur d'usure (AG) est inférieure à la valeur seuil d'usure (AGplf), la tension d'isolation tampon (VGNDLFT) est au moins égale à la différence entre le niveau de la première tension d'effacement (VYP) et ledit niveau de claquage (HVmax) des jonctions bipolaires du circuit commutateur de grille de commande (CGSW).

5. Procédé selon l'une des revendications 3 ou 4, dans lequel une région semiconductrice d'isolation (NISO) est polarisée à la première tension d'effacement (VYP), la région semiconductrice d'isolation (NISO) enveloppant le caisson semiconducteur (PW1) logeant les cellules mémoires, et le caisson semiconducteur tampon (PW2), dans des structures du type triple caisson.

6. Procédé selon l'une des revendications précédentes, dans lequel le cycle d'effacement comprend en outre, par l'intermédiaire du circuit commutateur de grille de commande (CGSW), une polarisation des grilles de commande des cellules mémoires non-sélectionnées à une tension de neutralisation (VPP).

7. Procédé selon la revendication 6, dans lequel, lorsque la valeur d'usure (AG) est inférieure à la valeur seuil d'usure (AGplf), le procédé comprend une augmentation du niveau de la tension de neutralisation (VPP), en valeur absolue, de façon à maintenir un écart initial constant par rapport audit niveau de la première tension d'effacement (VYP).

8. Procédé selon l'une des revendications 6 ou 7, dans lequel, lorsque la valeur d'usure (AG) est supérieure à la valeur seuil d'usure (AGplf), le procédé comprend un décalage (ΔD) du niveau de la tension de neutralisation (VPP) à un niveau de tension de neutralisation décalé (DVPP), et une augmentation du niveau de la tension de neutralisation décalée (DVPP), en valeur absolue, de façon à maintenir le décalage (ΔD) constant par rapport audit niveau de la première tension d'effacement (VYP).

9. Procédé selon la revendication 8, dans lequel, lorsque la valeur d'usure (AG) est supérieure à la valeur seuil d'usure (AGplf), le niveau de la première tension d'effacement (VYP) reste inchangé lorsque le niveau de la tension de neutralisation (VPP) atteint ledit niveau de claquage (HVmax) des jonctions bipolaires du circuit commutateur de grille de commande (CGSW).

10. Procédé selon l'une des revendications 1 à 8, dans lequel, lorsque la valeur d'usure (AG) est supérieure à la valeur seuil d'usure (AGplf), le niveau de la première tension d'effacement (VYP) reste inchangé à un niveau égal à une marge de tolérance prise sur ledit niveau de claquage (HVmax) des jonctions bipolaires du circuit commutateur de grille de commande (CGSW).

11. Circuit intégré de mémoire non-volatile (NVM) comprenant :
- des cellules mémoires logées dans un caisson semiconducteur (PW1) et comportant chacune un transistor d'état (TE) ayant une grille flottante (FG) et une grille de commande (CG), et
- des moyens d'effacement configurés, lors d'un cycle d'effacement, pour polariser le caisson semiconducteur (PW1) à une première tension d'effacement (VYP), **caractérisé en ce que** les moyens d'effacement sont configurés, en réponse à une augmentation d'une valeur d'usure (AG) des cellules mémoires supérieure à une valeur seuil d'usure (AGplf), pour augmenter le niveau de la première tension d'effacement (VYP), en valeur absolue, à un niveau supérieur à un niveau de claquage (HVmax) de jonctions bipolaires d'un circuit commutateur de grille de commande (CGSW).

12. Circuit intégré selon la revendication 11, dans lequel les moyens d'effacement sont configurés, lors du cycle d'effacement, pour polariser les grilles de commande des cellules mémoires sélectionnées à une deuxième tension d'effacement (VNN), par l'intermédiaire du circuit commutateur de grille de commande (CGSW).

13. Circuit intégré selon l'une des revendications 11 ou 12, comportant en outre un circuit périphérique (PRPH) et des transistors tampons (TBF1, TBF2) logés dans un caisson semiconducteur tampon (PW2), dans lequel les cellules mémoires sont couplées au circuit périphérique (PRPH) par l'intermédiaire de bornes de conduction des transistors tampons (TBF1, TBF2), le caisson semiconducteur tampon (PW2) et les grilles des transistors tampons (TBF1, TBF2) étant destinés à être polarisés à une tension d'isolation tampon (VGNDLFT) adaptée pour isoler le circuit périphérique (PRPH) de la première tension d'effacement (VYP).

14. Circuit intégré selon la revendication 13, dans lequel lorsque la valeur d'usure (AG) est supérieure à la valeur seuil d'usure (AGplf), un circuit de distribution (NISOVGEN) est configuré pour générer la tension d'isolation tampon (VGNDLFT) au moins égale à la différence entre le niveau de la première tension d'effacement (VYP) et ledit niveau de claquage (HVmax) des jonctions bipolaires du circuit commutateur de grille de commande (CGSW).

15. Circuit intégré selon l'une des revendications 13 ou 14, dans lequel le caisson semiconducteur (PW1) logeant les cellules mémoires est enveloppé par une région semiconductrice d'isolation (NISO) dans une structure du type triple caisson, et le caisson semiconducteur tampon (PW2) est également enveloppé par la même région semiconductrice d'isolation (NISO), dans une structure du type triple caisson, la région semiconductrice d'isolation (NISO) étant destinée à être polarisée à la première tension d'effacement (VYP).

16. Circuit intégré selon l'une des revendications 11 à 15, dans lequel les moyens d'effacement sont en outre configurés, lors d'un cycle d'effacement, pour polariser les grilles de commande des cellules mémoires non-sélectionnées (CGLnsel) à une tension de neutralisation (VPP), par l'intermédiaire du circuit commutateur de grille de commande (CGSW).

17. Circuit intégré selon la revendication 16, dans lequel, lorsque la valeur d'usure (AG) est inférieure à la valeur seuil d'usure (AGplf), les moyens d'effacement sont configurés pour augmenter le niveau de la tension de neutralisation (VPP), en valeur absolue, de façon à maintenir un écart initial constant par rapport audit niveau de la première tension d'effacement (VYP).

18. Circuit intégré selon l'une des revendications 16 ou 17, dans lequel, lorsque la valeur d'usure (AG) est supérieure à la valeur seuil d'usure (AGplf), les moyens d'effacement sont configurés pour décaler (ΔD) le niveau de la tension de neutralisation (VPP) à un niveau de tension de neutralisation décalé (DVPP), et augmenter le niveau de la tension de neutralisation décalé (DVPP), en valeur absolue, de façon à maintenir le décalage (ΔD) constant par rapport audit niveau de la première tension d'effacement (VYP).

19. Circuit intégré selon la revendication 18, dans lequel, lorsque la valeur d'usure (AG) est supérieure à la valeur seuil d'usure (AGplf), les moyens d'effacement sont configurés pour maintenir inchangé le niveau de la première tension d'effacement (VYP) lorsque le niveau de la tension de neutralisation (VPP) atteint ledit niveau de claquage (HVmax) des jonctions bipolaires du circuit commutateur de grille de commande (CGSW).

20. Circuit intégré selon l'une des revendications 11 à 15, dans lequel, lorsque la valeur d'usure (AG) est supérieure à la valeur seuil d'usure (AGplf), les moyens d'effacement sont configurés pour maintenir inchangé le niveau de la première tension d'effacement (VYP) lorsque le niveau de la première tension d'effacement (VYP) est égal à une marge de tolérance prise sur ledit niveau de claquage (HVmax) des jonctions bipolaires du circuit commutateur de grille de commande (CGSW).

## Patentansprüche

1. Verfahren zum Schreiben in einen nichtflüchtigen Speicher (NVM), welcher Speicherzellen beinhaltet, die in einem Halbleiter-Kasten (PW1) untergebracht sind, die jeweils einen Statustransistor beinhalten, der ein Float-Gate und ein Steuergate aufweist, wobei das Verfahren einen Löschzyklus umfasst, der eine Polarisierung des Halbleiter-Kastens (PW1) mit einer ersten Löschspannung (VYP) umfasst, **dadurch gekennzeichnet, dass** das Verfahren als Reaktion auf eine Erhöhung eines Verschleißwertes der Speicherzellen (AG) über einem Verschleißschwellenwert (AGplf) eine Erhöhung des Niveaus der ersten Löschspannung (VYP), als Absolutwert, auf ein Niveau über einem Durchschlagsniveau (HVmax) von bipolaren Verbindungsstellen eines Kommutierungsschaltkreises eines Steuergates (CGSW) des Speichers (NVM) umfasst.

2. Verfahren nach Anspruch 1, wobei der Löschzyklus eine Polarisierung der Steuergates der ausgewählten Speicherzellen mit einer zweiten Löschspannung (VNN) anhand des Kommutierungsschaltkreises eines Steuergates (CGSW) umfasst.

3. Verfahren nach einem der Ansprüche 1 oder 2, wobei der Speicher einen peripheren Schaltkreis (PRPH), Puffertransistoren (TBF1, TBF2), die in einem Puffer-Halbleiter-Kasten (PW2) untergebracht sind, beinhaltet, wobei die Speicherzellen anhand von Leitungsklemmen der Puffertransistoren (TBF1, TBF2) mit dem peripheren Schaltkreis (PRPH) gekoppelt sind, wobei der Puffer-Halbleiter-Kasten (PW2) und die Gates der Puffertransistoren (TBF1, TBF2) mit einer Pufferisolierungsspannung (VGNDLFT) polarisiert sind, die angepasst ist, um den peripheren Schaltkreis der ersten Löschspannung (VYP) zu isolieren.

4. Verfahren nach Anspruch 3, wobei, wenn der Verschleißwert (AG) kleiner als der Verschleißschwellenwert (AGplf) ist, die Pufferisolierungsspannung (VGNDLFT) mindestens gleich der Differenz zwischen dem Niveau der ersten Löschspannung (VYP) und dem Durchschlagsniveau (HVmax) der bipolaren Verbindungsstellen des Kommutierungsschaltkreises eines Steuergates (CGSW) ist.

5. Verfahren nach einem der Ansprüche 3 oder 4, wobei eine Isolierungshalbleiterregion (NISO) mit der ersten Löschspannung (VYP) polarisiert wird, wobei die Isolierungshalbleiterregion (NISO) den Halbleiter-Kasten (PW1), der die Speicherzellen unterbringt, und den Puffer-Halbleiter-Kasten (PW2) in Strukturen in der Art eines Dreifachkastens einhüllt.

6. Verfahren nach einem der vorstehenden Ansprüche, wobei der Löschzyklus weiter anhand der des Kommutierungsschaltkreises eines Steuergates (CGSW) eine Polarisierung der Steuergates der nicht ausgewählten Speicherzellen mit einer Neutralisierungsspannung (VPP) umfasst.

7. Verfahren nach Anspruch 6, wobei, wenn der Verschleißwert (AG) kleiner als der Verschleißschwellenwert (AGplf) ist, das Verfahren eine Erhöhung des Niveaus der Neutralisierungsspannung (VPP), als Absolutwert, umfasst, um eine ursprüngliche konstante Abweichung in Bezug auf das Niveau der ersten Löschspannung (VYP) beizubehalten.

8. Verfahren nach einem der Ansprüche 6 oder 7, wobei, wenn der Verschleißwert (AG) größer als der Verschleißschwellenwert (AGplf) ist, das Verfahren einen Versatz (ΔD) des Niveaus der Neutralisierungsspannung (VPP) auf ein versetztes Neutralisierungsspannungsniveau (DVPP), als Absolutwert, umfasst, um den konstanten Versatz (ΔD) in Bezug auf das Niveau der ersten Löschspannung (VYP) beizubehalten.

9. Verfahren nach Anspruch 8, wobei, wenn der Verschleißwert (AG) größer als der Verschleißschwellenwert (AGplf) ist, das Niveau der ersten Löschspannung (VYP) unverändert bleibt, wenn das Niveau der Neutralisierungsspannung (VPP) das Durchschlagsniveau (HVmax) der bipolaren Verbindungsstellen des Kommutierungsschaltkreises eines Steuergates (CGSW) erreicht.

10. Verfahren nach einem der Ansprüche 1 bis 8, wobei, wenn der Verschleißwert (AG) größer als der Verschleißschwellenwert (AGplf) ist, das Niveau der ersten Löschspannung (VYP) auf einem Niveau unverändert bleibt, das gleich einem Toleranzspielraum ist, der auf dem Durchschlagsniveau (HVmax) der bipolaren Verbindungsstellen des Kommutierungsschaltkreises eines Steuergates (CGSW) angenommen wird.

11. Integrierter Schaltkreis eines nichtflüchtigen Speichers (NVM), umfassend:
- Speicherzellen, die in einem Halbleiter-Kasten (PW1) untergebracht sind, und jeweils einen Statustransistor (TE) beinhalten, der ein Float-Gate (FG) und ein Steuergate (CG) aufweist, und
- Löschmittel, die bei einem Löschzyklus konfiguriert sind, um den Halbleiter-Kasten (PW1) mit einer ersten Löschspannung (VYP) zu polarisieren, **dadurch gekennzeichnet, dass** die Löschmittel als Reaktion auf eine Erhöhung eines Verschleißwertes der Speicherzellen (AG) über einem Verschleißschwellenwert (AGplf) konfiguriert sind, um das Niveau der ersten Löschspannung (VYP), als Absolutwert, auf ein Niveau über einem Durchschlagsniveau (HVmax) von bipolaren Verbindungsstellen eines Kommutierungsschaltkreises eines Steuergates (CGSW) zu erhöhen.

12. Integrierter Schaltkreis nach Anspruch 11, wobei die Löschmittel bei einem Löschzyklus konfiguriert sind, um die Steuergates der ausgewählten Speicherzellen mit einer zweiten Löschspannung (VNN) anhand des Kommutierungsschaltkreises eines Steuergates (CGSW) zu polarisieren.

13. Integrierter Schaltkreis nach einem der Ansprüche 11 oder 12, welcher weiter einen peripheren Schaltkreis (PRPH), und Puffertransistoren (TBF1, TBF2), die in einem Puffer-Halbleiter-Kasten (PW2) untergebracht sind, beinhaltet, wobei die Speicherzellen anhand von Leitungsklemmen der Puffertransistoren (TBF1, TBF2) mit dem peripheren Schaltkreis (PRPH) gekoppelt sind, wobei der Puffer-Halbleiter-Kasten (PW2) und die Gates der Puffertransistoren (TBF1, TBF2) dazu bestimmt sind, mit einer Pufferisolierungsspannung (VGNDLFT) polarisiert zu werden, die angepasst ist, um den peripheren Schaltkreis der ersten Löschspannung (VYP) zu isolieren.

14. Integrierter Schaltkreis nach Anspruch 13, wobei, wenn der Verschleißwert (AG) größer als der Verschleißschwellenwert (AGplf) ist, ein Verteilungsschaltkreis (NISOVGEN) konfiguriert ist, um die Pufferisolierungsspannung (VGNDLFT) zumindest gleich der Differenz zwischen dem Niveau der ersten Löschspannung (VYP) und dem Durchschlagsniveau (HVmax) der bipolaren Verbindungsstellen des Kommutierungsschaltkreises eines Steuergates (CGSW) zu erzeugen.

15. Integrierter Schaltkreis nach einem der Ansprüche 13 oder 14, wobei der Halbleiter-Kasten (PW1), der die Speicherzellen unterbringt, durch eine Isolierungshalbleiterregion (NISO) in einer Struktur in der Art eines Dreifachkastens eingehüllt ist, und der Puffer-Halbleiter-Kasten (PW2) ebenfalls durch dieselbe Isolierungshalbleiterregion (NISO) in einer Struktur in der Art eines Dreifachkastens eingehüllt ist, wobei die Isolierungshalbleiterregion (NISO) dazu bestimmt ist, mit der ersten Löschspannung (VYP) polarisiert zu werden.

16. Integrierter Schaltkreis nach einem der Ansprüche 11 bis 15, wobei die Löschmittel weiter bei einem Löschzyklus konfiguriert sind, um die Steuergates der nicht ausgewählten Speicherzellen (CGLnsel) mit einer Neutralisierungsspannung (VPP) anhand des Kommutierungsschaltkreises eines Steuergates (CGSW) zu polarisieren.

17. Integrierter Schaltkreis nach Anspruch 16, wobei, wenn der Verschleißwert (AG) kleiner als der Verschleißschwellenwert (AGplf) ist, die Löschmittel konfiguriert sind, um das Niveau der Neutralisierungsspannung (VPP), als Absolutwert, zu erhöhen, um eine ursprüngliche konstante Abweichung in Bezug auf das Niveau der ersten Löschspannung (VYP) beizubehalten.

18. Integrierter Schaltkreis nach einem der Ansprüche 16 oder 17, wobei, wenn der Verschleißwert (AG) größer als der Verschleißschwellenwert (AGplf) ist, die Löschmittel konfiguriert sind, um das Niveau der Neutralisierungsspannung (VPP) auf ein versetztes Neutralisierungsspannungsniveau (DVPP) zu versetzen (ΔD), und das Niveau des versetzten Neutralisierungsspannungsniveaus (DVPP), als Absolutwert, zu erhöhen, um den konstanten Versatz (ΔD) in Bezug auf das Niveau der ersten Löschspannung (VYP) beizubehalten.

19. Integrierter Schaltkreis nach Anspruch 18, wobei, wenn der Verschleißwert (AG) größer als der Verschleißschwellenwert (AGplf) ist, die Löschmittel konfiguriert sind, um das Niveau der ersten Löschspannung (VYP) unverändert zu halten, wenn das Niveau der Neutralisierungsspannung (VPP) das Durchschlagsniveau (HVmax) der bipolaren Verbindungsstellen des Kommutierungsschaltkreises eines Steuergates (CGSW) erreicht.

20. Integrierter Schaltkreis nach einem der Ansprüche 11 bis 15, wobei, wenn der Verschleißwert (AG) größer als der Verschleißschwellenwert (AGplf) ist, die Löschmittel konfiguriert sind, um das Niveau der ersten Löschspannung (VYP) unverändert zu halten, wenn das Niveau der ersten Löschspannung (VYP) gleich einem Toleranzspielraum ist, der auf dem Durchschlagsniveau (HVmax) der bipolaren Verbindungsstellen des Kommutierungsschaltkreises eines Steuergates (CGSW) angenommen wird.

## Claims

1. A method for writing in a non-volatile memory (NVM) including memory cells housed in a semiconductor well (PW1) each including a state transistor having a floating gate and a control gate, the method comprising an erase cycle comprising biasing the semiconductor well (PW1) to a first erase voltage (VYP), **characterised in that** the method comprises, in response to an increase in a memory cell wear value (AG) which is greater than a wear threshold value (AGplf), an increase in the level of the first erase voltage (VYP), in absolute value, to a higher level at a breakdown level (HVmax) of bipolar junctions of a control gate switch circuit (CGSW) of the memory (NVM).

2. The method according to claim 1, wherein the erase cycle comprises biasing the control gates of the selected memory cells to a second erase voltage (VNN), via the control gate switch circuit (CGSW).

3. The method according to one of claims 1 or 2, the memory including a peripheral circuit (PRPH), buffer transistors (TBF1, TBF2) housed in a buffer semiconductor well (PW2), the memory cells being coupled to the peripheral circuit (PRPH) via conduction terminals of the buffer transistors (TBF1, TBF2), in which buffer semiconductor well (PW2) and the gates of the buffer transistors (TBF1, TBF2) are biased to a buffer insulation voltage (VGNDLFT) adapted to isolate the peripheral circuit from the first erase voltage (VYP).

4. The method according to claim 3, wherein, when the wear value (AG) is less than the wear threshold value (AGplf), the buffer insulation voltage (VGNDLFT) is at least equal to the difference between the level of the first erase voltage (VYP) and said breakdown level (HVmax) of the bipolar junctions of the control gate switch circuit (CGSW).

5. The method according to one of claims 3 or 4, wherein a semiconductor insulation region (NISO) is biased to the first erase voltage (VYP), the semiconductor insulation region (NISO) enveloping the semiconductor well (PW1) housing the memory cells, and the buffer semiconductor well (PW2), in triple well type structures.

6. The method according to one of the preceding claims, wherein the erase cycle further comprises, via the control gate switch circuit (CGSW), biasing the control gates of the non-selected memory cells to a neutralisation voltage (VPP) .

7. The method according to claim 6, wherein, when the wear value (AG) is less than the wear threshold value (AGplf), the method comprises an increase in the level of the neutralisation voltage (VPP), in absolute value, so as to maintain a constant initial deviation relative to said level of the first erase voltage (VYP).

8. The method according to one of claims 6 or 7, wherein, when the wear value (AG) is greater than the wear threshold value (AGplf), the method comprises an offset (ΔD) from the level of the neutralisation voltage (VPP) to an offset neutralisation voltage level (DVPP), and an increase in the level of the offset neutralisation voltage (DVPP), in absolute value, so as to maintain the offset (ΔD) constant relative to said level of the first erase voltage (VYP).

9. The method according to claim 8, wherein, when the wear value (AG) is greater than the wear threshold value (AGplf), the level of the first erase voltage (VYP) remains unchanged when the level of the neutralisation voltage (VPP) reaches said breakdown level (HVmax) of the bipolar junctions of the control gate switch circuit (CGSW).

10. The method according to one of claims 1 to 8, wherein, when the wear value (AG) is greater than the wear threshold value (AGplf), the level of the first erase voltage (VYP) remains unchanged at a level which is equal to a margin of tolerance taken on said breakdown level (HVmax) of the bipolar junctions of the control gate switch circuit (CGSW).

11. A non-volatile memory integrated circuit (NVM) comprising:
- memory cells housed in a semiconductor well (PW1) and each including a state transistor (TE) having a floating gate (FG) and a control gate (CG), and
- erasing means configured, during an erase cycle, to bias the semiconductor well (PW1) to a first erase voltage (VYP), **characterised in that** the erasing means are configured, in response to an increase in a wear value (AG) of the memory cells which is greater than a wear threshold value (AGplf), to increase the level of the first erase voltage (VYP), in absolute value, to a level which is greater than a breakdown level (HVmax) of bipolar junctions of a control gate switch circuit (CGSW).

12. The integrated circuit according to claim 11, wherein the erasing means are configured, during the erase cycle, to bias the control gates of the selected memory cells to a second erase voltage (VNN), via the control gate switch circuit (CGSW).

13. The integrated circuit according to one of claims 11 or 12, further including a peripheral circuit (PRPH) and buffer transistors (TBF1, TBF2) housed in a buffer semiconductor well (PW2), wherein the memory cells are coupled to the peripheral circuit (PRPH) via conduction terminals of the buffer transistors (TBF1, TBF2), the buffer semiconductor well (PW2) and the gates of the buffer transistors (TBF1, TBF2) being intended to be biased to a buffer insulation voltage (VGNDLFT) adapted to insulate the peripheral circuit (PRPH) from the first erase voltage (VYP) .

14. The integrated circuit according to claim 13, wherein when the wear value (AG) is greater than the wear threshold value (AGplf), a distribution circuit (NISOVGEN) is configured to generate the buffer insulation voltage (VGNDLFT) which is at least equal to the difference between the level of the first erase voltage (VYP) and said breakdown level (HVmax) of the bipolar junctions of the control gate switch circuit (CGSW).

15. The integrated circuit according to one of claims 13 or 14, wherein the semiconductor well (PW1) housing the memory cells is enveloped by a semiconductor insulation region (NISO) in a triple well type structure, and the buffer semiconductor well (PW2) is also enveloped by the same semiconductor insulation region (NISO), in a triple well type structure, the semiconductor insulation region (NISO) being intended to be biased to the first erase voltage (VYP).

16. The integrated circuit according to one of claims 11 to 15, wherein the erasing means are further configured, during an erase cycle, to bias the control gates of the non-selected memory cells (CGLnsel) to a neutralisation voltage (VPP), via the control gate switch circuit (CGSW).

17. The integrated circuit according to claim 16, wherein, when the wear value (AG) is less than the wear threshold value (AGplf), the erasing means are configured to increase the level of the neutralisation voltage (VPP), in absolute value, so as to maintain a constant initial deviation relative to said level of the first erase voltage (VYP).

18. The integrated circuit according to one of claims 16 or 17, wherein, when the wear value (AG) is greater than the wear threshold value (AGplf), the erasing means are configured to offset (ΔD) the level of the neutralisation voltage (VPP) to an offset neutralisation voltage level (DVPP), and increase the level of the offset neutralisation voltage (DVPP), in absolute value, so as to maintain the offset (ΔD) constant relative to said level of the first erase voltage (VYP).

19. The integrated circuit according to claim 18, wherein, when the wear value (AG) is greater than the wear threshold value (AGplf), the erasing means are configured to maintain the level of the first erase voltage (VYP) unchanged when the level of the neutralisation voltage (VPP) reaches said breakdown level (HVmax) of the polar junctions of the control gate switch circuit (CGSW).

20. The integrated circuit according to one of claims 11 to 15, wherein, when the wear value (AG) is greater than the wear threshold value (AGplf), the erasing means are configured to maintain the level of the first erase voltage (VYP) unchanged when the level of the first erase voltage (VYP) is equal to a margin of tolerance taken on said breakdown level (HVmax) of the bipolar junctions of the control gate switch circuit (CGSW).
